# EUROPÄISCHE PATENTSCHRIFT

(11) **EP 1 405 400 B1**
(45) Veröffentlichungstag und Bekanntmachung des Hinweises auf die Patenterteilung: **04.05.2005**
(21) Anmeldenummer: 02752988.2
(22) Anmeldetag: 02.07.2002
(51) Int. Cl.: H03D 7/14

(54) **SCHNITTSTELLENSCHALTUNG ZUM ANSCHLUSS AN EINEN AUSGANG EINES FREQUENZUMSETZERS**
INTERFACE CIRCUIT FOR CONNECTING TO AN OUTPUT OF A FREQUENCY CONVERTER
CIRCUIT INTERFACE DESTINE A ETRE CONNECTE A UNE SORTIE D'UN CONVERTISSEUR DE FREQUENCE

(30) Priorität: 06.07.2001 DE 10132803
(43) Veröffentlichungstag der Anmeldung: 07.04.2004
(73) Patentinhaber: Infineon Technologies AG, 81669 München (DE)
(72) Erfinder: KLEIN, Peter, 83064 Raubling (DE); LUSTIG, Bernhard, 81737 München (DE); SEWALD, Dieter, 9434 Au/SG (CH)
(74) Vertreter: Fischer, Volker, Dipl.-Ing.
(86) Internationale Anmeldenummer: PCT/DE2002/002408
(87) Internationale Veröffentlichungsnummer: WO 2003/005561

(56) Entgegenhaltungen:
- WO-A-00/70756
- US-A- 5 613 233
- US-A- 5 872 446
- J. RUDELL : "A 1.9 GHZ WIDEBAND IF DOUBLE CONVERSION CMOS RECEIVER FOR CORDLESS TELEPHONE APPLICATIONS" IEEE JOURNAL OF SOLID STATE CIRCUITS , Bd. 32, Nr. 12, 1. Dezember 1997 (1997-12-01), Seiten 2071-2088, XP000767456 NEW YORK,US

## Beschreibung

Die vorliegende Erfindung betrifft eine Schnittstellenschaltung zum Anschluß an einen Ausgang eines Frequenzumsetzers.

In Hochfrequenz-Empfängern werden zur Umsetzung der hochfrequenten Sendesignale ins Basisband bevorzugt Mischer vom Gilbert-Typ eingesetzt. Diese können in analoger Schaltungstechnik in Bipolar- oder in Metal Oxide Semiconductor, MOS-Technik aufgebaut sein. Am Ausgang derartiger Mischer oder Frequenzumsetzer steht das heruntergemischte Ausgangssignal, das neben dem Nutzsignal auch noch Hochfrequenzreste enthält, zunächst als Ausgangsstrom bereit.

Um der nachfolgenden Signalverarbeitungskette ein um die Hochfrequenzreste bereinigtes Ausgangssignal bereitzustellen, ist es üblich, noch im Ausgangsstromzweig des Gilbert-Mischers an einem Widerstand den Ausgangsstrom in eine Spannung umzusetzen, so daß die Hochfrequenzreste effektiv über Kapazitäten abgeleitet werden können. Bei den in modernen Schaltungsintegrationstechniken in CMOS üblichen, kleinen Betriebsspannungen wird mit dem beschriebenen Widerstand der zur Verfügung stehende Spannungshub an den Mischertransistoren, und damit das erzielbare Leistungs-, Konversions- und Signal-Rausch-Verhältnis des Mischers durch den Spannungsabfall an einem derartigen Widerstand stark reduziert. Ohne Umsetzung des Mischerstroms in eine Spannung würden aber die Hochfrequenzreste an die nachfolgende Signalverarbeitungskette weitergegeben.

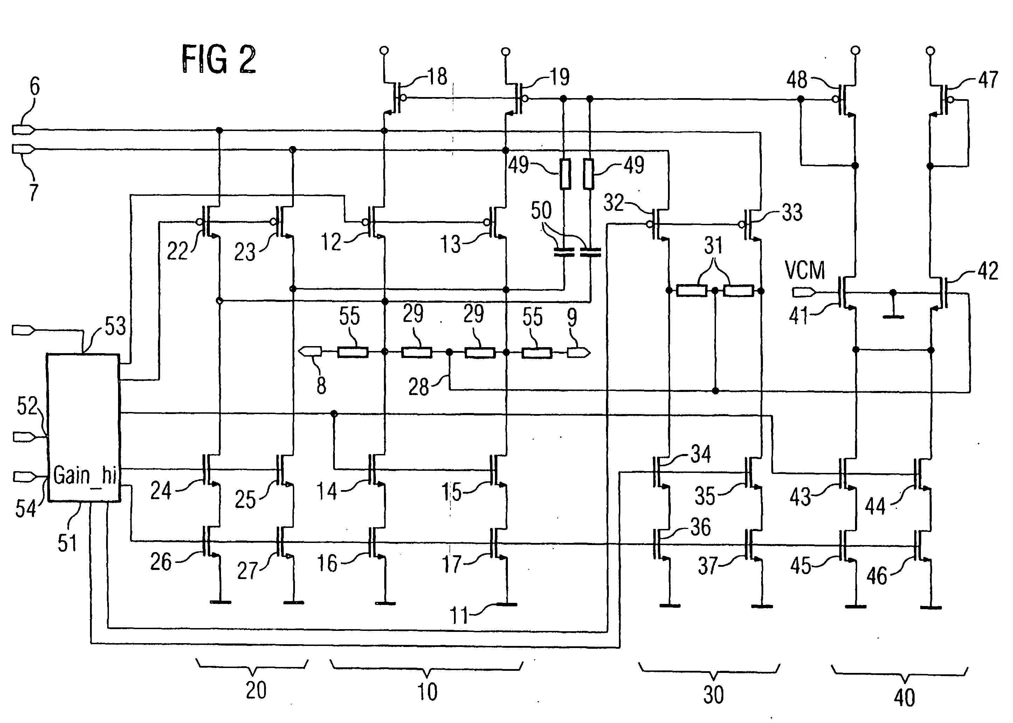

In dem Dokument A 2-V CMOS Cellular Transceiver Front-End, Steyaert et al., IEEE Journal of Solid-State Circuits, Vol. 35, No. 12, December 2000, pp. 1895 bis 1907 ist in Figur 2 eine derartige Mischerschaltung mit vorgeschaltetem rauscharmen Verstärker angegeben.

An am Ausgang der in Figur 2 angegebenen Mischerstufe geschalteten Widerständen würde an nachfolgende Stufen mit hohem Eingangswiderstand eine Differenzspannung weitergegeben, mit den oben beschriebenen Nachteilen, die sich an den relativ zu den Ausgangswiderständen des Mischers M5, M6 niederohmigen, ohmschen Lastwiderständen und den parallel geschalteten Lastkapazitäten zur Erzeugung eines Gleichtaktpegels zur Gleichspannungsoffsetkompensation aufbaut.

Um aus den oben beschriebenen Gründen einer nachfolgenden Schaltung mit niedrigem Eingangswiderstand den Differenzstrom der Mischertransistoren zukommen zu lassen, muß dieser Strom über Feedback-Widerstände geleitet werden, die für die Erzeugung des niedrigen Eingangswiderstands gebraucht werden ("virtuelle Masse). Um jedoch zugleich die erforderlichen RC-Zeit-konstanten von beispielsweise 10µsec zu erzielen, wie sie üblicherweise zur Kanalselektion im Basisband erforderlich sind, müßte man unverhältnismäßig große Kapazitäten, deren Integration in CMOS-Technik praktisch nicht realisierbar ist, aufbauen.

Bei der beschriebenen Direktumsetzung der hochfrequenten Übertragungssignale ins Basisband werden, um das bei MOS-Transistoren verhältnismäßig große 1/f-Rauschen zu unterdrükken, verhältnismäßig große Ströme benötigt, welche typischerweise in der Größenordnung einiger Milliampere liegen. Bei CMOS-Maximalspannungen von beispielsweise IV führt dies zu Lastwiderständen von einigen 100Ω. Eine RC-Zeitkonstante von 10µsec würde demnach einige 10nF an Kapazität erfordern, das heißt zirka einige 10mm² Chipfläche, was insbesondere bei hochintegrierten CMOS-Schaltungen eine kostenintensive Lösung wäre. Zudem müßte zusätzlich das Ausgangssignal von noch vorhandenen Hochfrequenzanteilen befreit werden, wozu ebenfalls große Kapazitäten vorzusehen wären, was wiederum zusätzliche Chipfläche erfordern würde.

In dem Dokument DE 69 31 61 55 T2 ist eine Schaltungsanordnung mit zwei Strompfaden angegeben, die je eine Kaskode-Stufe umfassen. Der Ausgangsstrom wird auf beide Pfade aufgeteilt. Außerdem ist eine Erfassung des Gleichtaktpegels mit entsprechender Rückführung vorgesehen.

Aufgabe der vorliegenden Erfindung ist es, eine Schnittstellenschaltung zum Anschluß an einen Ausgang eines Frequenzumsetzers anzugeben, welche die Basisband-Nutzsignale als Strom an nachfolgende Schaltungen weiterleitet, nicht jedoch die Hochfrequenzreste, damit diese effektiv über Kapazitäten abgeleitet werden können, den Gleichstromoffset des Frequenzumsetzer kompensiert, einen großen Dynamikbereich umfaßt, nachfolgenden Schaltungen einen definierten Ausgangssignalpegel anbietet, ohne zusätzlichen Strom programmierbare Verstärkung ermöglicht, und dabei kostengünstig herstellbar ist.

Erfindungsgemäß wird die Aufgabe gelöst durch eine Schnittstellenschaltung zum Anschluß an einen Ausgang eines Frequenzumsetzers, mit den Merkmalen des vorliegenden Patentanspruchs 1.

Der vorliegende Gegenstand beruht auf der Erkenntnis, daß eine Aufteilung des Eingangsstroms, welcher am Signaleingang der Schnittstellenschaltung zuführbar ist, auf drei Strompfade vorteilhafte Auswirkungen auf das Signal-Rausch-Verhältnis, den verarbeitbaren Dynamikbereich, sowie die Ausnutzung der zur Verfügung stehenden Versorgungsspannung, besonders in CMOS-Schaltungstechnik, bietet.

Gemäß der Erfindung kann beispielsweise der erste Strompfad zur Bereitstellung eines Ausgangsstroms am Signalausgang ausgelegt sein, während der zweite Strompfad den Anschluß zum Bereitstellen eines Gleichtaktsignals aufweist.

In einer alternativen Ausführungsform kann der erste Strompfad sowohl den Stromausgang als auch den Ausgang zum Bereitstellen des Gleichtaktsignals aufweisen. In diesem Fall ist bevorzugt ein Stromteiler vorgesehen, mit dem eine gewünschte Verstärkung oder Abschwächung des Ausgangssignals erzielbar ist.

Das Vorsehen weiterer Stromzweige ermöglicht zudem eine weiter verbesserte Anpassung an einen großen Dynamikbereich eines am Eingang anliegenden Signals durch Umschaltbarkeit zwischen verschiedenen Strompfaden mit unterschiedlichem oder gleichem Verstärkungs- oder Abschwächungsverhältnis des zu verarbeitenden Stroms.

Die vorliegende Schaltung ist besonders über ihrem Signaleingang zum Anschluß an den Ausgang eines Frequenzumsetzers, beispielsweise eines in CMOS-Schaltungstechnik gebildeten Frequenzumsetzers, geeignet. Die Erfindung ist bevorzugt in Hochfrequenzempfängern anwendbar, welche nach dem Direktumsetzungsprinzip ins Basisband arbeiten.

Das Stromteilungsverhältnis beziehungsweise das Verstärkungsoder Abschwächungsverhältnis des Stroms ist mit vorliegender Schaltung beliebig und auch dynamisch veränderbar.

Da die Schaltung einen Ausgang zum Bereitstellen eines Gleichtaktsignals aufweist, kann in einfacher Weise eine Kompensation von Gleichspannungsoffsets, die in Analogmultiplizierern üblicherweise auftreten können, erfolgen.

Da die vorliegende Schaltung eine Signalführung im Strombereich ohne zusätzliche Spannungsknoten aufweist, ist in der Schnittstellenschaltung nachfolgenden Filter- und Verstärkerschaltungen das Verhältnis von Nutz- zu Offsetspannungen deutlich verbessert.

Das Signal-Rausch-Verhältnis des Nutzsignals erhöht sich bei vorliegender Schnittstellenschaltung beträchtlich, weil die Spannungsamplitude des Nutzsignals klein bleibt, ohne das Signal-Rausch-Verhältnis zu verkleinern.

Da mit vorliegender Schaltung auch bei großem Dynamikbereich des Eingangssignals ein kleiner Ausgangsstrom bereitstellbar ist, können Schaltungen in der weiteren Signalverarbeitung im Basisband, die mit dem Ausgang der Schnittstellenschaltung gekoppelt sind, mit besonders geringem Flächen- und/oder Strombedarf aufgebaut sein, so daß insgesamt der Strombedarf des Empfängers verringert ist. Hierdurch ist die vorliegende Schaltung besonders zur Anwendung in mobilen Hochfrequenzempfängern geeignet.

In einer bevorzugten Ausführungsform der vorliegenden Erfindung ist eine Bias-Stufe vorgesehen, mit einem Ausgang, der je mit Steuereingängen der Kaskode-Stufen in erstem und zweitem Strompfad gekoppelt ist zur Zuführung jeweils einer Vorspannung.

Die mit den Kaskode-Stufen gekoppelte Bias-Stufe ermöglicht zum einen die Abschaltung der Strompfade in einem Stromsparmodus und zum anderen können, beispielsweise zum Umschalten der Verstärkung oder Abschwächung des Ausgangsstroms, einzelne Strompfade zu- oder abgeschaltet werden.

In einer weiteren, bevorzugten Ausführungsform der vorliegenden Erfindung weist die Bias-Stufe einen Steuereingang auf, zum steuersignalabhängigen Versetzen der Schnittstellenschaltung in eine stromsparende Betriebsart.

Insbesondere bei Anwendung der Schaltung im mobilen Bereich, das heißt beispielsweise als Mobilfunkempfänger, kann zum Abschalten der Schnittstellenschaltung oder zum Bereitstellen eines Stand-by-Modus eine deutlich längere Batterie- oder Akku-Lebensdauer erzielt werden.

Gemäß der vorliegenden Erfindung ist ein dritter Strompfad vorgesehen, der eine Kaskode-Stufe umfaßt, die in einer Parallelschaltung mit den Kaskode-Stufe des ersten und zweiten Strompfades gekoppelt ist, wobei die Kaskode-Stufen im zweiten und dritten Strompfad einen Steuereingang haben, der mit der Bias-Stufe zum Umschalten zwischen zweitem und drittem Strompfad verbunden ist.

In der beschriebenen, bevorzugten Ausführungsform ist der erste Strompfad zum einen mit dem Signalausgang zum Bereitstellen des Ausgangsstroms gekoppelt und weist zum anderen den Anschluß zum Bereitstellen eines Gleichtaktpegels auf.

In einer weiteren, bevorzugten Ausführungsform der vorliegenden Erfindung ist ein Stromteiler vorgesehen, der den Signalausgang, den Anschluß zum Bereitstellen eines Gleichtaktsignals und die Kaskode-Stufe im ersten Strompfad koppelt. Mit dem Stromteiler ist die gewünschte Abschwächung des Ausgangsstroms einstellbar.

In einer weiteren, bevorzugten Ausführungsform der vorliegenden Erfindung ist eine Regelungsschleife zur Gleichtaktunterdrückung vorgesehen mit einem Steuereingang, der mit dem Anschluß zum Bereitstellen eines Gleichtaktsignals verbunden ist und mit einem Ausgang, der mit dem Signaleingang der Schnittstellenschaltung gekoppelt ist.

In der Regelungsschleife kann beispielsweise ein Differenzverstärker vorgesehen sein, dem an einem Eingang das wie beschrieben bereitgestellte Gleichtaktsignal und an einem anderen Eingang eine Soll-Gleichtaktspannung, beispielsweise die halbe Versorgungsspannung, zuführbar ist.

In einer weiteren, bevorzugten Ausführungsform der vorliegenden Erfindung umfaßt die Regelungsschleife zur Gleichtaktunterdrückung Mittel zur Regelkreisstabilisierung.

Um ein unerwünschtes Oszillieren der Schaltung zu verhindern, kann beispielsweise eine Serienschaltung aus Widerstand und Kapazität in den Regelkreis eingeschaltet sein.

In einer weiteren, bevorzugten Ausführungsform der vorliegenden Erfindung sind der Signaleingang, der Signalausgang und die Strompfade zur Verarbeitung symmetrischer Signale ausgelegt.

Ein derartiger, differentieller Aufbau ermöglicht insbesondere in hochintegrierten CMOS-Schaltungen einen großen Signal-Rausch-Abstand. Zudem ist zugleich ein großer Dynamikbereich von beispielsweise 90 dB abdeckbar.

Weitere Einzelheiten der Erfindung sind Gegenstand der Unteransprüche.

Die Erfindung wird nachfolgend an einem Ausführungsbeispiele anhand der Zeichnungen näher erläutert.

Es zeigen
- Figur 1: eine bekannte Schnittstellenschaltung mit zwei parallelen, gefalteten Kaskode-Stufen anhand eines vereinfachten Schaltbilds und
- Figur 2: ein Ausführungsbeispiel der erfindungsgmäßen Schnittstellenschaltung mit drei parallelen, gefalteten Kaskode-Stufen anhand eines vereinfachten Schaltbilds.

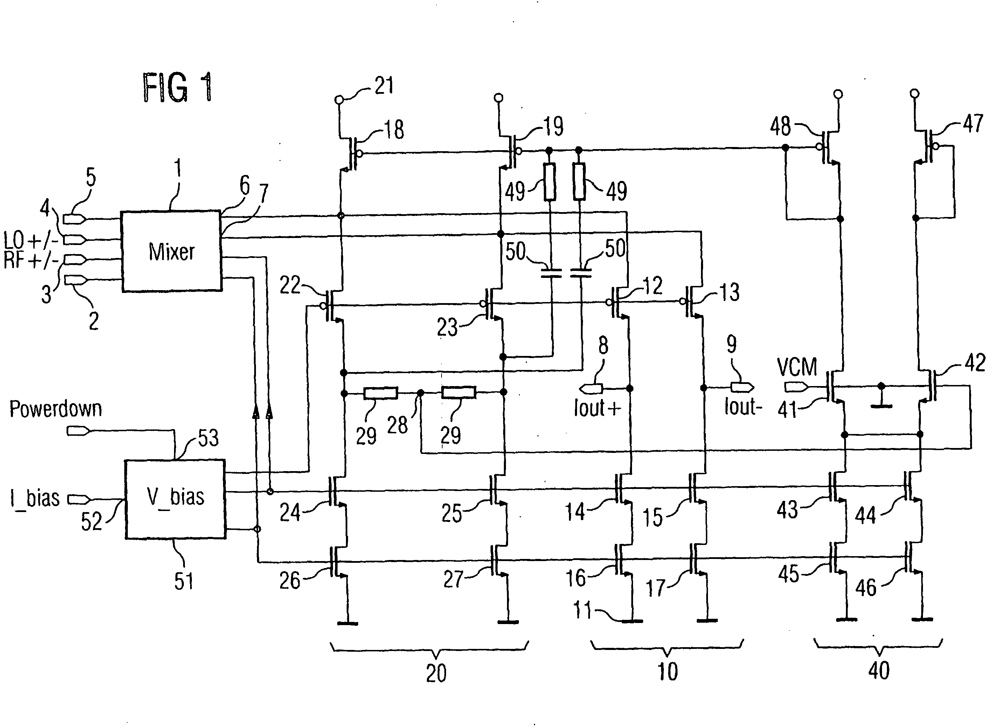

Figur 1 zeigt eine in CMOS-Schaltungstechnik aufgebaute Schnittstellenschaltung zum Anschluß an einen Ausgang eines Frequenzumsetzers 1.

Weist der Empfänger eine Architektur zur Verarbeitung komplexwertiger Signale auf, so sind für Inphase- und Quadratur-Zweig jeweils Schaltungen gemäß Figur 1 vorzusehen.

Der Frequenzumsetzer 1, der als Abwärtsmischer vom Gilbert-Typ aufgebaut ist, weist zwei Eingangsklemmenpaare 2 bis 5 auf, wobei am Eingangsklemmenpaar 2, 3 ein Hochfrequenzsignal als symmetrisches Signal zuführbar ist, welches beispielsweise in eine Empfangsantenne einkoppelt. Der Frequenzumsetzer mischt dieses Signal unter Verwendung eines Lokaloszillatorsignals ins Basisband herunter, wobei das Lokaloszillatorsignal ebenfalls als symmetrisches Signal an den Eingangsklemmen 4, 5 zuführbar ist. Der Frequenzumsetzer 1 stellt an seinem Ausgang 6, 7 dieses heruntergemischte Signal als Stromsignal bereit.

Der Signalausgang des Frequenzumsetzers 6, 7 ist zugleich der Signaleingang 6, 7 der erfindungsgemäßen Schnittstellenschaltung, welche das Ausgangssignal des Mischers zur weiteren Signalverarbeitung aufbereitet.

Die Schnittstellenschaltung stellt an ihrem Signalausgang 8, 9 das derart aufbereitete Ausgangssignal ebenfalls als Stromsignal in einem symmetrischen Ausgang bereit.

Die Schnittstellenschaltung umfaßt weiterhin einen ersten Strompfad, der den Signaleingang 6, 7 mit dem Signalausgang 8, 9 koppelt und ebenfalls symmetrisch aufgebaut ist. Zwischen dem Signaleingang 6, 7 und einem Bezugspotentialanschluß 11 umfaßt der symmetrische erste Strompfad 10 je eine Serienschaltung aus einem P-Kanal-MOS-Kaskode-Transistor 12, 13, einem N-Kanal-MOS-Kaskode-Transistor 14, 15 sowie bezugspotentialseitig einem N-Kanal-MOS-Transistor 16, 17, der als Stromquellentransistor arbeitet. Versorgungspotentialseitig sind zwei PMOS-Stromquellentransistoren 18, 19 vorgesehen, welche die PMOS-Kaskode-Transistoren 12, 13 jeweils mit Versorgungspotentialanschluß 21 koppeln. Die PMOS-Stromquellentransistoren 18, 19 sind zugleich Stromquellen für einen zweiten Strompfad 20, der zwischen Signaleingang 6, 7 und Bezugspotentialanschluß 11 parallel zum ersten Strompfad geschaltet ist. Die PMOS-Stromquellentransistoren 18, 19 verteilen den durch sie bereitgestellten Strom demnach auf den ersten und den zweiten Stromzweig 10, 20. Der zweite Stromzweig 20 weist wie der erste Stromzweig 10 in symmetrischem Aufbau je eine Serienschaltung aus PMOS-Kaskode-Transistoren 22, 23, NMOS-Kaskode-Transistoren 24, 25 und Stromquellentransistoren in NMOS-Technik 26, 27 auf, wobei diese Serienschaltungen jeweils die PMOS-Stromquellen 18, 19 mit Bezugspotentialanschluß 11 koppeln. Der zweite Stromzweig 20 weist weiterhin einen Anschluß zum Bereitstellen eines Gleichtaktsignals 28 auf, welches bei entsprechender Weiterverarbeitung, wie später erläutert, zur Gleichspannungsoffsetkompensation dient. Hierfür ist der Anschluß 28 über je einen Widerstand 29 mit je einem Schaltungsknoten des symmetrisch ausgebildeten zweiten Strompfads verbunden, nämlich jeweils zwischen Source-Anschluß der PMOS-Kaskode-Transistoren 22, 23 und Drain-Anschluß der NMOS-Kaskode-Transistoren 24, 25.

Die Schnittstellenschaltung umfaßt weiterhin eine Regelschleife 40, welche zur Kompensation von Gleichspannungsoffsets dient, die üblicherweise von Analogmultiplizierern wie dem Mischer 1 verursacht werden. Dabei ist eine Differenzverstärkerstufe vorgesehen, welche zwei source-seitig miteinander verbundene NMOS-Transistoren 41, 42 umfaßt, wobei dem NMOS-Transistor 41 ein Soll-Gleichtaktsignal VCM zuführbar ist und der Gate-Anschluß des weiteren NMOS-Differenzverstärkertransistors 42 mit dem Anschluß zur Bereitstellung des Gleichtaktsignals 28 verbunden ist.

Die sogenannten Bulk-Anschlüsse der Differenzverstärkertransistoren 41, 42 sind jeweils mit dem Bezugspotentialanschluß 11 verbunden. Der gemeinsame Source-Anschluß des Differenzverstärkers 41, 42 ist über eine Parallelschaltung aus zwei Serienschaltungen jeweils zweier NMOS-Transistoren 43 bis 46 mit Bezugspotentialanschluß 11 verbunden. Drainseitig ist einer der NMOS-Differenzverstärkertransistoren 42 über einen als Diode geschalteten PMOS-Transistor 47 mit Versorgungspotentialanschluß 21 verbunden. Der Drain-Anschluß des NMOS-Differenzverstärkertransistors 41 ist über einen Stromspiegeltransistor 48 zum einen über dessen Drain-Anschluß mit Bezugspotentialanschluß 21 gekoppelt und zum anderen über dessen Gateanschluß mit den Gate-Anschlüssen der PMOS-Stromquellentransistoren 18, 19 verbunden. Zur Stabilisierung des Regelkreises ist weiterhin je eine Serienschaltung aus einem Widerstand 49 und einer Kapazität 50 zum einen mit dem Gate-Anschluß des Stromspiegeltransistors 48 und zum anderen mit dem symmetrischen Schaltungsknoten zwischen PMOS- und NMOS-Kaskode-Transistoren 22 bis 25 im zweiten Strompfad 20 verbunden.

Zur Ansteuerung der PMOS- und NMOS-Kaskode-Transistoren 22 bis 25 sowie 12 bis 15 und der NMOS-Stromquellentransistoren 16, 17, 26, 27 in erstem und zweitem Stromzweig 10, 20 sind deren Gate-Anschlüsse jeweils mit einem Ausgang einer Bias-Stufe 51 verbunden, welche je eine entsprechende Vorspannung zum Betrieb der Transistoren bereitstellt. Der Bias-Stufe 51 ist zu ihrer Funktionsfähigkeit ein Referenzstrom an einem Stromeingang 52 zuführbar. Um die Schnittstellenschaltung in einen Stromsparmodus zu versetzen oder abzuschalten, ist die Bias-Stufe 51 mit einem weiteren Eingang 53 ausgestattet, an dem ein entsprechendes Steuersignal zuführbar ist.

Mit dem Signalausgang 8, 9 im ersten Strompfad 10 der vorliegenden Schaltung wird der am Eingang 6, 7 anliegende Strom zu einem Teil unmittelbar an eine Nachfolgeschaltung weitergegeben. Ein weiterer Teil des Stroms, welcher von den PMOS-Stromquellen 18, 19 bereitgestellt wird, fließt in den zweiten Strompfad 20, der als Stromsenke wirkt, jedoch zugleich den Anschluß 28 zur Bereitstellung eines Gleichtaktsignals zur Offsetkompensation aufweist.

Die Aufteilung des verhältnismäßig großen Mischerstroms auf mehrere, zum Mischerausgang parallele Kaskode-Stufen, welche entweder zur Gleichtaktermittlung oder zur Stromausgabe dienen, bietet eine wirtschaftlichere voll integrierte CMOS-Empfängerarchitektur. Während die N-Kanal-Kaskode-Transistoren, hauptsächlich zur Unterdrückung parasitärer Pole, bevorzugt eine möglichst geringe Kanallänge aufweisen, beispielsweise 0,4µm, haben die P-Kanal-Kaskode-Transistoren eine verhältnismäßig große Kanallänge, beispielsweise 2,5µm für die Transistoren 22, 23 und 4µm für die Transistoren 12, 13. Hierdurch wird das sogenannte 1/f-Rauschen weiter verringert. Weiterhin wird das Ausgangssignal aufgrund der kleinen Grenzfrequenz der Langkanaltransistoren von parasitären RF(Radio Frequency, Hochfrequenz)-Frequenzanteilen bereinigt und damit der Bedarf an großen und teuren Glättungskapazitäten reduziert.

In alternativen Schnittstellen schaltungen kann eine der Kaskode-Stufen auch entfallen, beispielsweise in der Schaltung gemäß Figur 1 können die NMOS-Kaskode-Transistoren 14, 15, 24, 25 weggelassen werden.

Die parallelen, gefalteten Kaskode-Stufen weisen jedoch zumindest je einen Kaskode-Transistor und je einen Stromquellentransistor auf, welche in einer Serienschaltung verbunden sind.

Die bekannte Schaltung gemäß Figur 1 dient zum Anschluß an einen N-Kanal-Mischer 1. Ist der Mischer 1 als P-Kanal-Mischer ausgebildet, so ist die Schnittstellenschaltung in einer dualen Ausführungsform in für den Fachmann naheliegender Weise zu realisieren. Hierfür ist die Anordnung gemäß Figur 1 zu spiegeln. Bekannte Ausführungsbeispiele für Mischer, für die die Schnittstellenschaltung gemäß Figur 1 geeignet ist, sind beispielsweise Ausführungsformen von Gilbert-Mischern, die eventuell auftretende Zwischenfrequenz-Störer mit großer Amplitude über eine Ausgangskapazität kurzschlieβen und einen Differenzstrom als Ausgangssignal liefern.

Die beschriebene Gleichtaktunterdrückung inklusive der Stabilisierungswiderstände- und Kapazitäten 49, 50 ist zur zuverlässigen Funktionsfähigkeit geeignet zu dimensionieren oder kann im Rahmen der üblichen Kenntnisse eines Fachmanns des betreffenden technischen Gebietes durch alternative Schaltungen zur Gleichtaktunterdrückung ersetzt werden.

In der gezeigten Schaltung liefert die Bias-Stufe 51 zusätzlich eine symmetrische Vorspannung für den Frequenzmischer 1 und ist hierfür ausgangsseitig mit einem weiteren Eingang des Frequenzumsetzers 1 verbunden.

Figur 2 zeigt ein Ausführungsbeispiel der vorliegenden Erfindung, welches besonders zur Verarbeitung von Eingangssignalen mit besonders großen Dynamikschwankungen des Eingangsstroms ausgelegt ist, wie sie beispielsweise bei GPRS oder UMTS-Mobilfunkstandard auftreten können.

Die Schnittstellenschaltung gemäß Figur 2, welche eine Weiterbildung der in Figur 1 beschriebenen Schaltung ist, weist ebenfalls einen Signaleingang 6, 7, der symmetrisch ausgebildet ist, auf, sowie einen ebenfalls symmetrisch ausgebildeten Signalausgang 8, 9. Zur Kopplung von Signaleingang und Signalausgang 6, 7; 8, 9 ist ebenfalls ein erster Strompfad 10 vorgesehen, der wie bereits in Figur 1 beschrieben eine Serienschaltung aus gemeinsam genutzten PMOS-Stromquellentransistoren 18, 19, PMOS-Kaskode-Transistoren 12, 13, NMOS-Kaskode-Transistoren 14, 15 sowie NMOS-Stromquellentransistoren 16, 17 gemäß der bereits in Figur 1 beschriebenen Verschaltung umfaßt. Die beschriebenen Serienschaltungen sind dabei zwischen Versorgungspotentialanschluß 21 und Bezugspotentialanschluß 11 angeschlossen. Parallel zu diesem ersten Stromzweig 10 ist wiederum ein zweiter Stromzweig 20 geschaltet, der wie bereits in Figur 1 beschrieben, eine Serienschaltung aus Kaskode-Transistoren in PMOS-Technik 22, 23, NMOS-Kaskode-Transistoren 24, 25, und NMOS-Stromquellentransistoren 26, 27 umfaßt, wobei versorgungspotentialseitig die PMOS-Stromquellentransistoren gemeinsam im ersten und zweiten Strompfad 10, 20 wirksam sind.

In Abweichung zur Schaltung gemäß Figur 1 sind bei der Ausführung gemäß Figur 2 jedoch die Widerstände 29, die den Anschluß 28 zur Bereitstellung des Gleichtaktsignals bilden, nicht im zweiten Strompfad 20 angeordnet, sondern vielmehr im ersten Stromzweig 10 angeordnet, wo sie mit weiteren Widerständen 55 einen symmetrischen Stromteiler für das Ausgangssignal der Schnittstellenschaltung bilden. Dabei ist angenommen, daß der Ausgangsknoten niederohmig ist, zum Beispiel durch Rückkopplung der Folgeschaltung auf diesen Knoten. Im einzelnen sind Widerstände 29 mit je einem Anschluß zwischen Source-Anschluß der PMOS-Kaskode-Transistoren 12, 13 und Drain-Anschluß der NMOS-Kaskode-Transistoren 14, 15 geschaltet, während sie mit je einem weiteren Anschluß miteinander verbunden sind und den Anschluß zur Bereitstellung des Gleichtaktsignals 28 bilden. Über die weiteren Widerstände 55 ist dieser symmetrische Schaltungsknoten zwischen PMOS- und NMOS-Kaskode-Stufe 12, 13; 14, 15 mit dem Signalausgang 8, 9 verbunden, an dem somit ein heruntergeteiltes Stromsignal bereitgestellt ist. An diesem Ausgang steht demnach nur noch der sich aus der Stromteilung aus Widerstandswert des Widerstands 29 geteilt durch die Summe aus den Widerstandswerten der Widerstände 29 und 55 ergebende Stromanteil an, falls wie später erläutert, keine weitere Stromteilung beziehungsweise -reduzierung durch weitere Strompfade 20, 30 erfolgt.

Wie bereits zu Figur 1 erläutert, ist eine Regelungsschleife 40 vorgesehen, mit einem Differenzverstärker 41, 42, sowie NMOS-Transistoren 43, 44, 45, 46, dem als Diode geschalteten PMOS-Transistor 47, dem Stromspiegeltransistor 48 und den Stabilisierungsgliedern 49, 50. Die genaue Verschaltung der genannten Bauelemente der Regelungsschleife 40 wurde bereits für Figur 1 in Aufbau und Funktion erläutert und soll hier an dieser Stelle nicht noch einmal wiederholt werden. Im Unterschied zu der Schaltung gemäß Figur 1 koppeln die Mittel zur Stabilisierung 49, 50 jedoch nicht nur in den zweiten Strompfad, sondern auch in den ersten Strompfad im Schaltungsknoten zwischen PMOS- und NMOS-Kaskode-Transistoren ein.

Weiterhin im Unterschied zur Schaltung gemäß Figur 1 ist bei der weitergebildeten Schaltung gemäß Figur 2 ein weiterer, dritter Stromzweig 30 vorgesehen, der parallel zu erstem und zweitem Strompfad 10, 20 geschaltet ist, wobei wiederum die PMOS-Stromquellentransistoren 18, 19 mit verwendet werden, und der ebenfalls symmetrisch ausgebildet ist. Der dritte Strompfad 30 weist je eine Serienschaltung aus PMOS-Kaskode-Transistoren 32, 33, NMOS-Kaskode-Transistoren 34, 35 und NMOS-Stromquellentransistoren 36, 37 auf, mit einer Verschaltung in Analogie zum ersten und zweiten Strompfad. Der dritte Strompfad 30 arbeitet als Stromsenke zur Reduzierung des Ausgangsstroms der Schnittstellenschaltung. Hierfür ist der symmetrische, zwischen PMOS- und NMOS-Kaskode-Stufen 32, 33; 34, 35 gebildete Schaltungsknoten über je einen Widerstand 31 mit dem Anschluß 29 zur Bereitstellung des Gleichtaktsignals verbunden.

Da die in Figur 2 ebenfalls vorhandene Bias-Stufe 51 mit den PMOS- und NMOS-Kaskode-Stufen der ersten bis dritten Stromzweige 10 bis 30 jeweils unabhängig voneinander verbunden ist, ist derart eine Umschaltung zwischen zweitem und drittem Strompfad 20, 30 ermöglicht. Der erste Strompfad 10, an dem das Ausgangssignal der Schaltung ableitbar ist, ist dabei stets aktiv, außer gegebenenfalls beim Stromsparmodus. Für diesen Stromsparmodus ist ein Steuereingang 53 an der Bias-Stufe 51 vorgesehen. Zusätzlich zum an der Bias-Stufe 53 ebenfalls vorgesehenen Stromreferenzeingang 52 ist ein Umschalteingang 54 zum Umschalten der Stromverstärkung beziehungsweise -abschwächung der vorliegenden Schnittstellenschaltung ermöglicht, was wiederum die bereits eingangs erwähnte Verarbeitung von Signalen mit großem Dynamikumfang erlaubt.

Während die Stromzweige 10, 20 in Figur 1 unterschiedlich dimensioniert sind, sind die Strompfade 20, 30 gemäß Figur 2 parallel geschaltet und gleich dimensioniert. Die Ausgänge der Kaskode-Stufen 22 bis 25 im zweiten Strompfad 20 sind mit dem Ausgang der Kaskode-Stufen im ersten Strompfad 10 unmittelbar gekoppelt. Die Ausgänge der Kaskode-Stufen im dritten Strompfad 30 hingegen sind wie bereits beschrieben mit der Kaskode-Stufe im 1 Strompfad zur Gleichtaktunterdrückung über Widerstände 31 gekoppelt. Das Stromteilerverhältnis kann neben dem beschriebenen Stromteiler 29, 55 im ersten Strompfad 10 nun durch wechselweises Zu- oder Abschalten von zweitem oder dritten Strompfad 20, 30 weiter verändert werden. Sofern mehr als zwei Teilungsverhältnisse des Stromteilers gewünscht sind, ist eine Erweiterung der Schaltung gemäß Figur 2 in einer für einen Fachmann mit Kenntnis der Schaltung gemäß Figur 2 naheliegenden Weise möglich. Mit dem am Steuereingang 53 zuführbaren Stromsparmodus-Signal können die PMOS-Kaskode-Stufen 12, 13, 22, 23, 32, 33 abgeschaltet werden. Zusätzlich können jedoch die PMOS-Kaskode-Stufen 22, 23 beziehungsweise 32, 33 einzeln abgeschaltet werden, um die beschriebene Stromteilerverhältnis-Umschaltung zu erzielen.

Das Abschalten des zweiten Strompfads 20 und Zuschalten des dritten Strompfads 30 bewirkt dabei neben der Stromteilung im Stromteiler 28, 55 ein weiteres Dämpfen beziehungsweise Herunterteilen des Ausgangsstroms der Schnittstellenschaltung, beispielsweise bei besonders starkem Empfangssignal. Durch die durch die Widerstände 29 und 55 vorgegebene Stromteilung wird aber im Ausgangssignal weniger Rauschen erzeugt als durch eine Stromteilung durch Umschalten von Strompfaden auf gleichen Ausgangsstrom.

### Bezugszeichenliste

- 1: Frequenzumsetzer
- 2: RF-Eingang
- 3: RF-Eingang
- 4: LO-Eingang
- 5: LO-Eingang
- 6: Eingang
- 7: Eingang
- 8: Ausgang
- 9: Ausgang
- 10: erster Strompfad
- 11: Bezugspotentialanschluß
- 12: PMOS-FET
- 13: PMOS-FET
- 14: NMOS-FET
- 15: NMOS-FET
- 16: NMOS-FET
- 17: NMOS-FET
- 18: PMOS-FET
- 19: PMOS-FET
- 20: zweiter Strompfad
- 21: Versorgungspotentialanschluß
- 22: PMOS-FET
- 23: PMOS-FET
- 24: NMOS-FET
- 25: NMOS-FET
- 26: NMOS-FET
- 27: NMOS-FET
- 28: Gleichtaktsignalanschluß
- 29: Widerstand
- 30: dritter Strompfad
- 31: Widerstand
- 32: PMOS-FET
- 33: PMOS-FET
- 34: NMOS-FET
- 35: NMOS-FET
- 36: NMOS-FET
- 37: NMOS-FET
- 40: Regelschleife
- 41: NMOS-FET
- 42: NMOS-FET
- 43: NMOS-FET
- 44: NMOS-FET
- 45: NMOS-FET
- 46: NMOS-FET
- 47: PMOS-Diode
- 48: Stromspiegeltransistor
- 49: Widerstand
- 50: Kapazität
- 51: Bias-Stufe
- 52: Eingang
- 53: Eingang
- 54: Eingang
- 55: Widerstand

## Patentansprüche

1. Schnittstellenschaltung zum Anschluß an einen Ausgang eines Frequenzumsetzers (1), aufweisend
- einen Signaleingang (6, 7),
- einen Signalausgang (8, 9),
- einen ersten Strompfad (10), der den Signaleingang (6, 7) mit dem Signalausgang (8, 9) koppelt und zumindest eine Kaskode-Stufe (12, 13) umfaßt,
- einen zweiten Strompfad (20), der eine Kaskode-Stufe (22, 23) umfaßt, die parallel zu der Kaskode-Stufe (12, 13) des ersten Strompfads (10) geschaltet ist,
- einen Anschluß zum Bereitstellen eines Gleichtaktsignals (28), der im ersten oder im zweiten Strompfad (10, 20) angeordnet ist, und
- einen dritten Strompfad (30), der eine Kaskode-Stufe (32, 33) umfaßt, die in einer Parallelschaltung mit den Kaskode-Stufen (12, 13, 22, 23) des ersten und zweiten Strompfads (10, 20) gekoppelt ist, wobei die Kaskode-Stufen im zweiten und dritten Strompfad (20, 30) je einen Steuereingang haben, der mit einer Bias-Stufe (51) zum Umschalten zwischen zweitem und drittem Strompfad (20, 30) verbunden ist.

2. Schnittstellenschaltung nach Anspruch 1,
**dadurch gekennzeichnet, daß** die Bias-Stufe (51) mit einem Ausgang versehen ist, der jeweils mit Steuereingängen der Kaskode-Stufen (12, 13, 22, 23) im ersten und zweiten Strompfad (10, 20) gekoppelt ist zur Zuführung je einer Vorspannung.

3. Schnittstellenschaltung nach Anspruch 2,
**dadurch gekennzeichnet, daß**
die Bias-Stufe (51) einen Steuereingang (53) aufweist zum steuersignalabhängigen Versetzen der Schnittstellenschaltung in eine stromsparende Betriebsart.

4. Schnittstellenschaltung nach einem der Ansprüche 1 bis 3,
**dadurch gekennzeichnet, daß**
ein Stromteiler (29, 55) vorgesehen ist, der den Signalausgang (8, 9), den Anschluß zum Bereitstellen eines Gleichtaktsignals (29) und die Kaskode-Stufe im ersten Strompfad (12, 13) koppelt.

5. Schnittstellenschaltung nach einem der Ansprüche 1 bis 4,
**dadurch gekennzeichnet, daß**
eine Regelungsschleife (40) zur Gleichtaktunterdrückung vorgesehen ist, mit einem Steuereingang, der mit dem Anschluß zum Bereitstellen eines Gleichtaktsignals (28) verbunden ist und mit einem Ausgang, der mit dem Signaleingang (6, 7) der Schnittstellenschaltung gekoppelt ist.

6. Schnittstellenschaltung nach Anspruch 5,
**dadurch gekennzeichnet, daß**
die Regelungsschleife zur Gleichtaktunterdrückung Mittel zur Regelkreisstabilisierung (49, 50) umfaßt.

7. Schnittstellenschaltung nach einem der Ansprüche 1 bis 6,
**dadurch gekennzeichnet, daß**
der Signaleingang (6, 7), der Signalausgang (8, 9) und die Strompfade (10, 20) zur Verarbeitung symmetrischer Signale ausgelegt sind.

## Claims

1. An interface circuit for connection to an output of a frequency converter (1), having
- a signal input (6, 7),
- a signal output (8, 9),
- a first current path (10), which couples the signal input (6, 7) to the signal output (8, 9) and comprises at least one cascode stage (12, 13),
- a second current path (20), which comprises a cascode stage (22, 23) connected in parallel with the cascode stage (12, 13) of the first current path (10),
- a connection for providing a common-mode signal (28) which is arranged in the first or in the second current path (10, 20), and
- a third current path (30), which comprises a cascode stage (32, 33) coupled in a parallel circuit with the cascode stages (12, 13, 22, 23) of the first and second current paths (10, 20), the cascode stages in the second and third current paths (20, 30) each having a control input connected to a bias stage (51) for changing over between the second and third current path (20, 30).

2. The interface circuit as claimed in claim 1,
**characterized in that**
the bias stage (51) has an output coupled in each case to control inputs of the cascode stages (12, 13, 22, 23) in the first and second current paths (10, 20), for supplying a respective bias voltage.

3. The interface circuit as claimed in claim 2,
**characterized in that**
the bias stage (51) has a control input (53) for putting the interface circuit into a current-saving operating mode in a manner dependent on a control signal.

4. The interface circuit as claimed in one of claims 1 to 3,
**characterized in that**
a current divider (29, 55) is provided, which couples the signal output (8, 9), the connection for providing a common-mode signal (29) and the cascode stage in the first current path (12, 13).

5. The interface circuit as claimed in one of claims 1 to 4,
**characterized in that**
a control loop (40) for common-mode rejection is provided, with a control input connected to the connection for providing a common-mode signal (28) and with an output coupled to the signal input (6, 7) of the interface circuit.

6. The interface circuit as claimed in claim 5,
**characterized in that**
the control loop for common-mode rejection comprises means for control circuit stabilization (49, 50).

7. The interface circuit as claimed in one of claims 1 to 6,
**characterized in that**
the signal input (6, 7), the signal output (8, 9) and the current paths (10, 20) are designed for processing symmetrical signals.

## Revendications

1. Circuit d'interface de raccordement à une sortie d'un convertisseur (1) de fréquence, comprenant
- une entrée (6, 7) de signal,
- une sortie (8, 9) de signal,
- un premier chemin (10) de courant qui couple l'entrée (6, 7) de signal à la sortie (8, 9) de signal et qui comprend au moins un étage cascode (12,13),
- un deuxième chemin (20) de courant qui comprend un étage cascode (22, 23) monté en parallèle à l'étage cascode (12, 13) du premier chemin (10) de courant,
- une borne de mise à disposition d'un signal (28) de mode commun, qui est disposée dans le premier ou dans le deuxième chemin (10, 20) de courant, et
- un troisième chemin (30) de courant, qui comprend un étage cascode (32, 33), qui est couplé suivant un circuit parallèle aux étages cascode (12, 13, 22, 23) du premier et du deuxième chemin (10, 20) de courant, les étages cascode des deuxième et troisième chemins (20, 30) de courant ayant respectivement une entrée de commande, qui est reliée à un étage de polarisation (51) pour commuter entre le deuxième et le troisième chemin (20, 30) de courant.

2. Circuit d'interface suivant la revendication 1,
**caractérisé en ce que** l'étage de polarisation (51) est muni d'une sortie qui, pour l'envoi d'une tension de polarisation, est couplée respectivement aux entrées de commande des étages cascode (12, 13, 22, 23) du premier et du deuxième chemin (10, 20) de courant.

3. Circuit d'interface suivant la revendication 2,
**caractérisé en ce que** l'étage de polarisation (51) a une entrée (53) de commande pour mettre, en fonction du signal de commande, le circuit d'interface dans un type de fonctionnement permettant d'économiser du courant.

4. Circuit d'interface suivant l'une des revendications 1 à 3,
**caractérisé en ce qu'**il est prévu un diviseur (29, 55) de courant qui couple la sortie (8, 9) de signal, la borne de mise à disposition d'un signal (29) en mode commun et les étages cascode du premier chemin (12, 13) de courant.

5. Circuit d'interface suivant l'une des revendications 1 à 4,
**caractérisé en ce qu'**il est prévu une boucle (40) de régulation pour supprimer le mode commun, qui comprend une entrée de commande qui est reliée à la borne de mise à disposition d'un signal (28) en mode commun et une sortie qui est couplée à l'entrée (6, 7) de signal du circuit d'interface.

6. Circuit d'interface suivant la revendication 5,
**caractérisé en ce que** la boucle de régulation de suppression du mode commun comprend des moyens (49, 50) de stabilisation du circuit de régulation.

7. Circuit d'interface suivant l'une des revendications 1 à 6,
**caractérisé en ce que** l'entrée (6, 7) du signal, la sortie (8, 9) du signal et les chemins (10, 20) de courant sont conçus pour traiter des signaux symétriques.
